Europäisches Patentamt

(19) European Patent Office

Office européen des brevets

(11) **EP 0 695 944 B1**

(12) **FASCICULE DE BREVET EUROPEEN**

(45) Date de publication et mention
de la délivrance du brevet:
**20.02.2002 Bulletin 2002/08**

(51) Int Cl.⁷: **G01R 19/155**, H02G 1/02

(21) Numéro de dépôt: **95401838.8**

(22) Date de dépôt: **04.08.1995**

(54) **Détecteur de tension unipolaire, notamment pour ligne électrique aérienne**

Einpoliger Spannungsprüfer, insbesondere für elektrische Freileitung

Single-pole voltage tester, especially for electrical overhead line

(84) Etats contractants désignés:
**DE ES GB IT**

(30) Priorité: **05.08.1994 FR 9409762**

(43) Date de publication de la demande:
**07.02.1996 Bulletin 1996/06**

(73) Titulaire: **SOCIETE ANONYME DES ETS CATU
F-92222 Bagneux (FR)**

(72) Inventeur: **Bouchez, Bernard
F-92220 Bagneux (FR)**

(74) Mandataire: **CABINET BONNET-THIRION
12, Avenue de la Grande-Armée
75017 Paris (FR)**

(56) Documents cités:
**EP-A- 0 061 983        FR-A- 2 365 805
FR-A- 2 432 174**

EP 0 695 944 B1

**Description**

La présente invention concerne d'une manière générale le contrôle de la présence ou non d'une tension sur une quelconque ligne électrique, et elle vise plus particulièrement, mais non nécessairement exclusivement, le cas des lignes électriques aériennes haute tension, qu'il s'agisse de lignes de distribution de courant ou de lignes de transport d'énergie

Pour l'exécution de travaux sur une telle ligne électrique, il importe que celle-ci soit hors tension, ou, autrement dit, qu'elle se trouve dûment "consignée".

Pour le contrôle correspondant, il est usuellement mis en oeuvre un détecteur de tension unipolaire comportant, à l'abri d'une cage de Faraday, entre une électrode de contact et une masse métallique communément appelée contrepoids et extérieure à cette cage de Faraday, une résistance de charge aux bornes de laquelle est établi un circuit de détection pilotant au moins un élément de signalisation, tel que voyant lumineux ou autre.

En pratique, ce détecteur de tension est disposé au bout d'une perche, et, par son électrode de contact, qui forme antenne, l'opérateur vient au contact de la ligne électrique à contrôler.

Il se forme, alors, entre le contrepoids et la terre, une capacité parasite, qui fait intervenir aussi bien la perche que l'opérateur lui-même, et dont il résulte la circulation d'un micro-courant dans la résistance de charge.

Dûment relevée par le circuit de détection, la tension correspondante aux bornes de la résistance de charge est comparée à une tension de référence, et le circuit de détection actionne en conséquence l'élément de signalisation associé.

Par exemple, cet élément de signalisation est formé de deux voyants lumineux, l'un rouge, qui est allumé dans le cas de la présence d'une tension, et l'autre, vert, qui est allumé après une action de test et qui reste allumé en l'absence d'une tension.

Un détecteur de tension du type ci-dessus est par exemple décrit dans le document FR-A-2 432 174.

L'une des difficultés, en l'espèce, tient à ce qu'il faut occulter la présence éventuelle d'une tension induite sur la ligne électrique contrôlée.

Cette tension induite, due à la présence de lignes électriques environnantes, peut en pratique atteindre 10 à 15 % de la tension d'origine.

Il importe donc, pour qu'elle ne soit pas détectée, et, qu'ainsi, l'opérateur puisse, suivant une procédure de sécurité déterminée, continuer, sur la ligne électrique consignée concernée, l'action entreprise sur celle-ci, que la sensibilité du détecteur de tension soit prévue en conséquence.

Il en résulte, inévitablement, une limitation de la plage de tension susceptible d'être détectée.

Or, corollairement, il est souhaitable, notamment pour limiter le nombre de détecteurs de tension de caractéristiques différentes nécessaire, que cette plage de tension soit aussi large que possible.

Plus précisément, il est aujourd'hui demandé que les tensions extrêmes de cette plage soient entre elles dans le rapport de un à trois.

L'expérience montre, et les essais confirment, qu'avec les détecteurs de tension de type usuel, dans lesquels, de manière traditionnelle, le contrepoids est formé par une plaque qui s'étend transversalement par rapport à l'axe de la cage de Faraday et dont la surface n'est en pratique pas négligeable, il est très difficile, sinon impossible, de satisfaire à l'ensemble des tests de laboratoire auxquels se réfèrent les dispositions normatives en la matière et qui, suivant des "modèles" déterminés, sont supposés représentatifs des divers cas critiques auxquels doit répondre un détecteur de tension du genre en cause.

En pratique, trois tests de laboratoire sont proposés à ce sujet.

Suivant l'un d'eux, l'élément de signalisation doit se trouver à coup sûr excité si la tension à détecter est supérieure à une fraction, inférieure à la moitié, de la tension nominale en service.

Suivant un autre, l'élément de signalisation ne doit au contraire pas se trouver excité si la tension à détecter est égale à une fraction réduite, comprise entre un dixième et deux dixièmes, de cette tension nominale en service.

Suivant le troisième, enfin, qui correspond à la détection éventuelle d'une tension induite, l'élément de signalisation ne doit pas non plus se trouver excité pour un fonctionnement inverse du détecteur de tension, c'est-à-dire pour un champ perturbateur en opposition de phase, si la tension à contrôler est égale à une fraction donnée, supérieure à la moitié, de la tension nominale en service.

La présente invention a d'une manière générale pour objet une disposition permettant de satisfaire à ces trois tests de laboratoire, même pour une plage de tension étendue.

De manière plus précise, elle a pour objet un détecteur de tension unipolaire, notamment pour ligne électrique aérienne, du genre comportant, à l'abri d'une cage de Faraday, entre une électrode de contact et un contrepoids extérieurs à cette cage de Faraday ayant un axe longitudinal, une résistance de charge aux bornes de laquelle est établi un circuit de détection pilotant au moins un élément de signalisation, ce détecteur de tension étant d'une manière générale caractérisé en ce que la distance L séparant le contrepoids de l'électrode de contact, d'une part, et la surface utile S de ce contrepoids, d'autre part, satisfont conjointement aux deux inégalités suivantes :

$$L > 200 \text{ mm} \qquad \text{(I)}$$

$$50 \text{ mm}^2 < S < 500 \text{ mm}^2 \qquad (II)$$

Il s'avère, en effet, qu'en éloignant de l'électrode de contact le contrepoids, et en réduisant la surface utile de ce contrepoids, c'est-à-dire sa surface à l'air, on minimise avantageusement l'influence sur le contrepoids d'un éventuel champ perturbateur intervenant en opposition de phase, et, notamment, celui dû à une éventuelle tension de fuite, en rendant au contraire prépondérant son influence sur l'électrode de contact.

Il s'avère, également, que, pour des raisons de même type, il est avantageux que le contrepoids s'étende longitudinalement par rapport à la cage de Faraday, suivant l'axe de celle-ci, par exemple, ou parallèlement à cet axe.

Grâce à une telle configuration du contrepoids, les lignes de champ d'un éventuel champ perturbateur sont avantageusement recoupées radialement, c'est-à-dire transversalement, suivant une moindre dimension, au lieu de s'étendre tangentiellement suivant une dimension largement supérieure, ce qui minimise, encore, son influence sur le contrepoids.

Suivant une forme préférée de réalisation de l'invention, le contrepoids est en pratique formé par un simple fil conducteur, et, plus précisément, par le fil unique, ou l'un des fils, d'un câble électrique blindé dont le blindage, écourté, appartient à la cage de Faraday en formant un prolongement de celle-ci.

Il en résulte une réalisation particulièrement simple, économique et efficace de l'ensemble.

Les caractéristiques et avantages de l'invention ressortiront d'ailleurs de la description qui va suivre, à titre d'exemple, en référence aux dessins schématiques annexés sur lesquels :

> la figure 1 est un schéma d'un détecteur de tension suivant l'invention ;
> la figure 2 est un schéma de même type, mais avec mise en oeuvre d'un circuit de test ;
> la figure 3 est une vue en perspective d'une réalisation pratique d'un détecteur de tension suivant l'invention ;
> la figure 4 en est une vue en perspective éclatée ;
> la figure 5 en est, avec des arrachements locaux, et sans l'électrode de contact ni l'embout d'adaptation, une vue en coupe axiale, suivant, globalement, la ligne V-V de la figure 3.

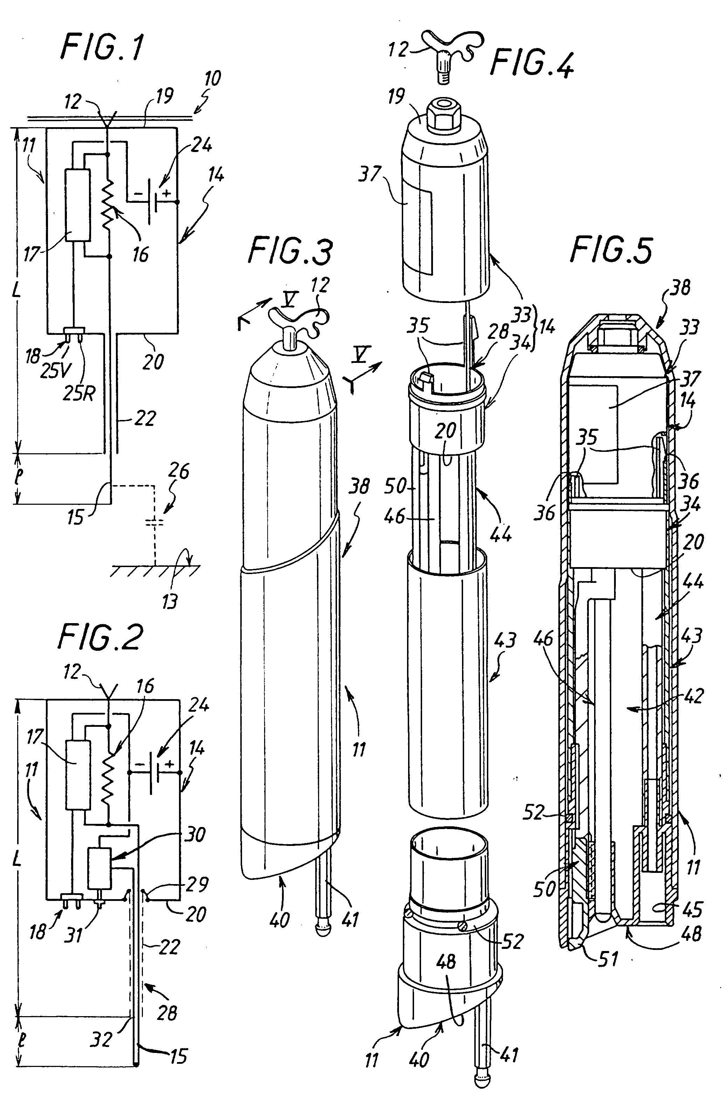

Tel qu'illustré sur la figure 1, il s'agit, globalement, de contrôler l'absence, ou la présence, d'une éventuelle tension sur une ligne électrique 10, qui, en pratique, est une ligne électrique aérienne.

De manière connue en soi, il est mis en oeuvre, à cet effet, un détecteur de tension 11, qui est en pratique un détecteur de tension unipolaire, et qui, destiné à venir au contact de la ligne électrique 10 par une électrode de contact 12 formant antenne, en étant pour ce faire manipulé en bout d'une perche non représentée, intervient en pratique par effet capacitif entre cette ligne électrique 10 et la terre 13.

De manière également connue en soi, le détecteur de tension 11 comporte, globalement, à l'abri d'une cage de Faraday 14, entre l'électrode de contact 12, qui est extérieure à cette cage de Faraday 14 tout en étant en liaison électrique avec celle-ci, et un contrepoids 15, qui est également extérieur à cette cage de Faraday 14, mais sans liaison électrique avec celle-ci, une résistance de charge 16 aux bornes de laquelle est établi un circuit de détection 17 pilotant un élément de signalisation 18.

Suivant l'invention, la distance L séparant le contrepoids 15 de l'électrode de contact 12, d'une part, et la surface utile S du contrepoids 15, c'est-à-dire sa surface à l'air, d'autre part, satisfont conjointement aux deux inégalités suivantes :

$$L > 200 \text{ mm} \qquad (I)$$

$$50 \text{ mm}^2 < S < 500 \text{ mm}^2 \qquad (II)$$

L'inégalité (I) traduit un éloignement relatif du contrepoids 15 vis-à-vis de l'électrode de contact 12.

L'inégalité (II) traduit sa minimisation relative par rapport à l'ensemble.

Schématiquement, la cage de Faraday 14 se présente sous la forme d'une boîte cylindrique, fermée par une paroi transversale à l'une et l'autre de ses extrémités.

L'électrode de contact 12 est implantée au centre de sa paroi transversale sommitale 19.

Le contrepoids 15 s'étend du côté opposé, au-delà de la paroi transversale de base 20 correspondante.

Préférentiellement, et tel que représenté, le contrepoids 15 suivant l'invention s'étend longitudinalement par rapport à la cage de Faraday 14.

Par exemple, figure 1, il s'étend suivant l'axe de la cage de Faraday 14, à l'abri d'un prolongement tubulaire 22 de celle-ci issu de la zone centrale de sa paroi transversale de base 20.

Préférentiellement, et tel que représenté, le contrepoids 15 suivant l'invention est formé par un simple fil conducteur, directement raccordé à la borne correspondante de la résistance de charge 16.

Plus exactement, le contrepoids 15 est formé par la partie d'un tel fil qui s'étend au-delà de la cage de Faraday 14, et, donc, en l'espèce, au-delà du prolongement tubulaire 22 de celle-ci.

Soit $\underline{l}$ la longueur que présente ainsi longitudinalement le contrepoids 15, c'est-à-dire parallèlement à l'axe de la cage de Faraday 14.

Cette longueur l est une fraction de la distance L précédente.

Cette fraction est en pratique comprise entre un cinquième et un vingtième, en étant par exemple voisine d'un dixième.

De bons résultats ont en tout cas été obtenus avec une longueur l comprise entre 2 et 4 cm, en étant en pratique voisine de 3 cm.

Quoi qu'il en soit, la surface utile S du contrepoids 15 est pour l'essentiel celle de sa surface latérale.

Elle dépend donc de sa longueur l et de sa section.

Le circuit de détection 17 est bien connu par lui-même, et, ne relevant pas de la présente invention, il ne sera pas décrit ici.

De manière usuelle, il est prévu, pour sa desserte, dans la cage de Faraday 14, une source de tension continue 24 autonome.

Il s'agit, en pratique, d'une ou plusieurs piles, ou d'une batterie d'accumulateurs.

Préférentiellement, et tel que représenté, c'est la borne positive de cette source de tension continue 24 qui est reliée à la cage de Faraday 14, tandis que sa borne négative est reliée au circuit de détection 17.

De manière connue en soi, l'élément de signalisation 18 comporte, par exemple, au moins un voyant lumineux.

En pratique, il comporte deux voyants lumineux 25V, 25R, l'un vert, l'autre rouge, et il s'agit par exemple de simples diodes électroluminescentes.

Par exemple, et tel que représenté, ces voyants lumineux 25V, 25R sont portés par la cage de Faraday 14, et, plus précisément, par la paroi transversale de base 20 de celle-ci.

Lorsque, par son électrode de contact 12, le détecteur de tension 11 est au contact de la ligne électrique 10, il se développe, entre le contrepoids 15 et la terre 13, tel que schématisé en traits interrompus sur la figure 1, une capacité parasite 26.

Il en résulte la circulation, dans la résistance de charge 16, d'un micro-courant.

La tension alors présente aux bornes de la résistance de charge 16, dûment détectée par le circuit de détection 17, est comparée, par ce circuit de détection 17, à une tension de référence déduite de celle délivrée par la source de tension continue 24.

Suivant la tension détectée, les voyants lumineux 25V, 25R interviennent en conséquence.

Dans la forme de réalisation schématisée à la figure 2, le contrepoids 15 est formé par l'un des fils d'un câble électrique blindé 28 dont le blindage, écourté pour laisser libre la longueur de fil l nécessaire à la constitution de ce contrepoids 15, appartient, comme précédemment, à la cage de Faraday 14, en formant en pratique le prolongement tubulaire 22 de celle-ci.

Autrement dit, par des moyens de connexion 29, qui sont de type usuel, et qui ne seront donc pas décrits ici, le blindage formant le prolongement tubulaire 22 est convenablement raccordé à la cage de Faraday 14, et, en pratique, à la paroi transversale de base 20 de celle-ci.

Dans la forme de réalisation représentée, ce prolongement tubulaire 22 est excentré par rapport à la cage de Faraday 14, tout en s'étendant parallèlement à l'axe de celle-ci, et il en est donc de même pour le contrepoids 15.

Il est prévu, par ailleurs, dans la forme de réalisation représentée, un circuit de test 30, sous la dépendance d'un bouton de test 31 à la disposition de l'usager.

Suivant des dispositions qui, bien connues par elles-mêmes, ne seront pas décrites ici, ce circuit de test 30 est apte à appliquer au circuit de détection 17, en parallèle vis-à-vis de la résistance de charge 16, une tension de contrôle déterminée, pour permettre de s'assurer du bon fonctionnement de l'ensemble.

Suivant l'invention, le circuit de test 30 intervient entre le circuit de détection 17 et un fil conducteur 32 raccordé à l'extrémité libre de celui formant le contrepoids 15, ce qui permet, également, de s'assurer de la continuité de ce dernier.

En pratique, comme le fil formant le contrepoids 15, le fil conducteur 32 appartient au câble électrique blindé 28.

Dans la forme de réalisation représentée sur les figures 3 à 5, la cage de Faraday 14 est formée, d'une part, d'une pièce en forme de cloche 33, au sommet de laquelle intervient l'électrode de contact 12, cette électrode de contact 12 étant par exemple rapportée par vissage sur la paroi transversale sommitale 19 correspondante, et, d'autre part, d'une pièce formant embase 34, qui, en forme de corps de boîte, ferme à sa base la pièce en forme de cloche 33, en comportant la paroi transversale de base 20 correspondante, et qui est traversée par le fil conducteur dont l'extrémité forme le contrepoids 15.

Par exemple, la pièce en forme de cloche 33 est en métal, et la pièce formant embase 34 est en matière synthétique métallisée.

Dans la forme de réalisation représentée, la pièce formant embase 34 et la pièce en forme de cloche 33 sont solidarisées de manière débrayable l'une à l'autre par encliquetage.

Par exemple, et tel que représentée, la pièce formant embase 34 porte, en saillie suivant des génératrices, des pattes élastiquement déformables 35, par lesquelles elle peut venir en prise avec des crans 36 complémentaires prévus à cet effet sur la pièce en forme de cloche 33.

La pièce en forme de cloche 33 contient le circuit de détection 17 et le circuit de test 30, non visibles sur les figures 3 à 5, et, accessible par une trappe 37 amovible, la source de tension continue 24, également non visible sur ces figures 3 à 5.

La pièce formant embase 34 porte, elle, sur la paroi transversale de base 20, l'élément de signalisation 18 et le bouton de test 31, également non visibles sur les figures 3 à 5.

L'ensemble est à l'abri d'une enveloppe extérieure 38, qui est en forme de cloche allongée, et qui est fermée à sa base par un culot 40 porteur d'un embout d'adaptation 41 pour permettre de rapporter, de manière usuelle, sur une perche non représentée, le détecteur de tension 11 ainsi constitué.

Bien entendu, l'enveloppe extérieure 38, et le culot 40, sont en matière isolante, et, en pratique, en matière synthétique.

Entre la cage de Faraday 14 et le culot 40, l'enveloppe extérieure 38 ménage tout l'espace 42 nécessaire à l'éloignement du fil conducteur formant à son extrémité le contrepoids 15 vis-à-vis de l'électrode de contact 12 et à l'extension de ce fil.

En pratique, un fourreau tubulaire 43, coaxial de l'enveloppe extérieure 38, relie à emboîtement la cage de Faraday 14 au culot 40 pour la délimitation de l'espace 42.

Dans la forme de réalisation représentée, la pièce formant embase 34 de la cage de Faraday 14 porte en saillie sur sa surface inférieure, c'est-à-dire en saillie sur la paroi transversale de base 20 de cette embase 34, un tube 44, pour le logement et la protection du fil conducteur formant à son extrémité le contrepoids 15, et, plus précisément, du câble électrique blindé 28, non représenté sur la figure 5, auquel ce fil appartient.

Dans la forme de réalisation représentée, ce tube 44 se trouve dans l'alignement d'un logement 45 à la faveur duquel l'embout d'adaptation 41 peut être rapporté sur le culot 40.

Il est en outre prévu, dans l'enveloppe extérieure 38, et, plus précisément, dans l'espace 42 délimité par le fourreau tubulaire 43, entre la cage de Faraday 14 et le culot 40, pour chacun des voyants lumineux 25V, 25R, non visibles sur les figures 3 à 5, un guide de lumière 46, qui, disposé au droit d'un tel voyant lumineux 25V, 25R, débouche à l'extérieur du culot 40, sur la paroi transversale de base 48 de celui-ci.

De même, il est prévu, dans l'enveloppe extérieure 38, une réglette 50, dont l'extrémité 51 est accessible de l'extérieur du culot 40, sur la paroi transversale de base 48 de celui-ci, et qui, pour permettre d'agir sur le bouton de test 31, non visible sur les figures 3 à 5, est montée mobile dans cette enveloppe extérieure 38, entre le culot 40 et la cage de Faraday 14, parallèlement à l'axe de cette cage de Faraday 14.

Enfin, dans la forme de réalisation représentée, un joint d'étanchéité 52 est prévu entre le culot 40 et l'enveloppe extérieure 38.

Bien entendu, la présente invention ne se limite pas aux formes de réalisation décrites et représentées, mais englobe toute variante d'exécution.

En particulier, au lieu d'être formé de voyants lumineux, l'élément de signalisation mis en oeuvre peut par exemple être formé, ou comporter, un avertisseur sonore.

En outre, suivant des modalités pratiques usuelles en la matière, des dispositions peuvent être prises pour s'affranchir de toutes les éventuelles capacités parasites.

Enfin, le domaine d'application de l'invention n'est pas limité aux seules lignes électriques aériennes, mais s'étend aussi bien à n'importe quel élément susceptible d'être sous tension, et, par exemple, aux jeux de barres dans les postes de distribution.

## Revendications

1. Détecteur de tension unipolaire, notamment pour ligne électrique aérienne, du genre comportant, à l'abri d'une cage de Faraday (14) ayant un axe longitudinal, entre une électrode de contact (12) et un contrepoids (15) extérieurs à cette cage de Faraday (14), une résistance de charge (16) aux bornes de laquelle est établi un circuit de détection (17) pilotant au moins un élément de signalisation (18), **caractérisé en ce que**, la distance L séparant le contrepoids (15) de l'électrode de contact (12), d'une part, et la surface utile S dudit contrepoids (15), d'autre part, satisfont conjointement aux deux inégalités suivantes :

$$L > 200 \text{ mm} \qquad (I)$$

$$50 \text{ mm}^2 < S < 500 \text{ mm}^2 \qquad (II)$$

2. Détecteur de tension suivant la revendication 1, **caractérisé en ce que** le contrepoids (15) s'étend longitudinalement par rapport à la cage de Faraday (14), c'est-à-dire suivant l'axe de celle-ci ou parallèlement à cet axe.

3. Détecteur de tension suivant l'une quelconque des revendications 1, 2, **caractérisé en ce que** le contrepoids (15) est formé par un fil conducteur.

4. Détecteur de tension suivant la revendication 3, **caractérisé en ce que** le contrepoids (15) est formé par l'un des fils d'un câble électrique blindé (28) dont le blindage, écourté pour laisser libre la longueur (l) de fil nécessaire à la constitution de ce contrepoids (15), est convenablement raccordé à la cage de Faraday (14), en formant un prolongement tubulaire (22) de celle-ci.

5. Détecteur de tension suivant l'une quelconque des revendication 3, 4, **caractérisé en ce que**, un circuit de test (30) étant prévu, sous la dépendance d'un bouton de test (31) à la disposition de l'opérateur, ledit circuit de test (30) est apte à appliquer au circuit de détection (17), en parallèle vis à vis de la résistance de charge (16), une tension de contrôle déterminée et intervient entre le circuit de détection (17) et un fil conducteur (32) raccordé à l'extrémité libre de celui formant le contrepoids (15).

6. Détecteur de tension suivant l'une quelconque des revendications 3 à 5, **caractérisé en ce que** la cage de Faraday (14) est formée, d'une part, d'une pièce en forme de cloche (33), au sommet de laquelle intervient l'électrode de contact (12), et, d'autre part, d'une pièce formant embase (34), qui ferme à sa base la pièce en forme de cloche (33), et qui est traversée par le fil conducteur formant le contrepoids (15).

7. Détecteur de tension suivant la revendication 6, **caractérisé en ce que** la pièce formant embase (34) porte en saillie sur sa surface inférieure un tube (44) pour le logement et la protection du fil conducteur formant le contrepoids (15).

8. Détecteur de tension suivant l'une quelconque des revendications 6, 7, **caractérisé en ce que** la pièce formant embase (34) et la pièce en forme de cloche (33) sont solidarisées l'une à l'autre par encliquetage.

9. Détecteur de tension suivant l'une quelconque des revendications 3 à 8, **caractérisé en ce qu'**il comporte une enveloppe extérieure (38), en forme de cloche, qui est fermée à sa base par un culot (40), et qui ménage, entre la cage de Faraday (14) et ledit culot (40), l'espace (42) nécessaire à l'éloignement du fil conducteur formant le contrepoids (15) vis-à-vis de l'électrode de contact (12) et à l'extension de ce fil.

10. Détecteur de tension suivant la revendication 9, **caractérisé en ce que**, l'élément de signalisation (18) comportant au moins un voyant lumineux (25V, 25R) porté par la cage de Faraday (14), il est prévu, dans l'enveloppe extérieure (38), entre ladite cage de Faraday (14) et le culot (40), un guide de lumière (46), qui, disposé au droit dudit voyant lumineux (25V, 25R), débouche à l'extérieur dudit culot (40).

11. Détecteur de tension suivant la revendication 10, **caractérisé en ce que**, un circuit de test (30) étant prévu, sous la dépendance d'un bouton de test (31), il est également prévu, dans l'enveloppe extérieure (38), une réglette (50), dont l'extrémité (51) est accessible de l'extérieur du culot (40), et qui, pour permettre d'agir sur le bouton de test (31), est montée mobile dans cette enveloppe extérieure (38), entre ledit culot (40) et la cage de Faraday (14).

12. Détecteur de tension suivant l'une quelconque des revendications 1 à 11, **caractérisé en ce qu'**une source de tension continue (24) autonome étant prévue pour la desserte du circuit de détection (17), c'est la borne positive de cette source de tension continue (24) qui est reliée à la cage de Faraday (14).

13. Détecteur de tension suivant l'une quelconque des revendications 1 à 12, **caractérisé en ce que** la longueur (l) du contrepoids (15) parallèlement à l'axe de la cage de Faraday (14) est une fraction de la distance L.

14. Détecteur de tension suivant la revendication 13, **caractérisé en ce que** cette fraction est comprise entre un cinquième et un vingtième.

**Patentansprüche**

1. Einpoliger Spannungsprüfer, insbesondere für elektrische Freileitung, der Art umfassend geschützt in bzw. gesichert durch einen Faraday'schen Käfig (14), der eine Längsachse aufweist, zwischen einer Kontaktelektrode (12) und einem Gegengewicht (15) außerhalb dieses Faraday'schen Käfigs (14), einen Last- bzw. Ladungswiderstand (16), an dessen Anschlußklemmen eine Detektionsschaltung (17) angeordnet ist, die wenigstens ein Signalisierelement (18) steuert, **dadurch gekennzeichnet, daß** einerseits der Abstand L, der das Gegengewicht (15) von der Kontaktelektrode (12) trennt, und andererseits die benutzbare Oberfläche S des Gegengewichts (15) gemeinsam den folgenden zwei Ungleichungen genügen:

$$L > 200 \text{ mm} \qquad (I)$$

$$50 \text{ mm}^2 < S < 500 \text{ mm}^2 \qquad (II).$$

2. Spannungsprüfer nach Anspruch 1, **dadurch gekennzeichnet, daß** das Gegengewicht (15) sich in Längsrichtung in bezug auf den Faraday'schen Käfig (14) erstreckt, d.h. entlang der Achse desselben oder parallel zu dieser.

3. Spannungsprüfer nach einem der Ansprüche 1 oder 2, **dadurch gekennzeichnet, daß** das Gegengewicht (15) aus einem leitfähigem Draht gebildet ist.

4. Spannungsprüfer nach Anspruch 3, **dadurch gekennzeichnet, daß** das Gegengewicht (15) aus einem der Drähte eines elektrisch gekapselten bzw. geschirmten Kabels (28) gebildet ist, dessen Kapselung bzw. Abschirmung, welche gekürzt ist, um die für die Ausbildung dieses Gegengewichtes (15) notwendige Länge (I) freizulassen, geeignet bzw. entsprechend an den Faraday'schen Käfig (14) angeschlossen ist, indem es eine rohrförmige Verlängerung (22) desselben ausbildet.

**5.** Spannungsprüfer nach einem der Ansprüche 3 oder 4, **dadurch gekennzeichnet, daß** eine Testschaltung (30) in Abhängigkeit von einem Testknopf (31) zur Verfügung des Betätigers vorgesehen ist, welche Testschaltung (30) geeignet ist, an die Detektionsschaltung (17) parallel in bezug auf den Ladungswiderstand (16) eine bestimmte Steuerspannung bzw. Kontrollspannung anzulegen, und zwischen der Detektionsschaltung (17) und einem an das freie Ende desjenigen, der das Gegengewicht (15) bildet, angeschlossenen Leitungsdraht (32) angeordnet ist.

**6.** Spannungsprüfer nach einem der Ansprüche 3 bis 5, **dadurch gekennzeichnet, daß** der Faraday'sche Käfig (14) einerseits von einem Stück in Form einer Glocke (33) an deren Scheitel die Kontaktelektrode (12) angreift, und andererseits aus einem eine Basis (34) bildenden Stück gebildet ist, welches an seiner Basis das glockenförmige Stück (33) verschließt, und welches durch den das Gegengewicht (15) bildenden leitfähigen Draht durchquert ist.

**7.** Spannungsprüfer nach Anspruch 6, **dadurch gekennzeichnet, daß** das die Basis bildende Stück (34) vor- bzw. aufragend auf seiner unteren Oberfläche ein Rohr (44), für die Lagerung und den Schutz des das Gegengewicht (15) bildenden leitfähigen Drahtes aufweist.

**8.** Spannungsprüfer nach einem der Ansprüche 6 oder 7, **dadurch gekennzeichnet, daß** das die Basis (34) bildende Stück und das Stück in Form einer Glocke (33) miteinander durch Klemmen bzw. Klipsen bzw. Rasten verbunden sind.

**9.** Spannungsprüfer nach einem der Ansprüche 3 bis 8, **dadurch gekennzeichnet, daß** er eine äußere Hülle (38) in Form einer Glocke umfaßt, welche an ihrer Basis von einem Sockel bzw. einer Fassung (40) abgeschlossen ist, und welche zwischen dem Faraday'schen Käfig (14) und dem Sockel (40) den notwendigen Platz (42) für die Entfernung bzw. Beabstandung des leitfähigen Drahtes, der das Gegengewicht (15) bildet, gegenüber der Kontaktelektrode (12) und in Verlängerung dieses Drahtes schafft.

**10.** Spannungsprüfer nach Anspruch 9, **dadurch gekennzeichnet, daß**, da das Signalisierelement (18) wenigstens eine Leuchtanzeige (25V, 25R) umfaßt, die durch den Faraday'schen Käfig (14) getragen ist, in der äußeren Hülle (38) zwischen dem Faraday'schen Käfig (14) und dem Sockel (40) ein Lichtleiter (46) vorgesehen ist, welcher an der Stelle der Anzeigevorrichtung (25V, 25R) angeordnet außerhalb des Sockels (40) mündet.

**11.** Spannungsprüfer nach Anspruch 10, **dadurch gekennzeichnet, daß**, da ein Testschaltkreis (30) in Abhängigkeit von einem Testknopf (31) vorgesehen ist, ebenfalls in der Außenumhüllung (38) eine Reglette (50) vorgesehen ist, deren Ende (51) vom Äußeren des Sockels (40) zugängig ist, und welche, um ein Einwirken auf den Testkopf (31) zu erlauben, beweglich in dieser äußeren Hülle (38) zwischen dem Sockel (40) und dem Faraday'schen Käfig (14) angeordnet ist.

**12.** Spannungsprüfer nach einem der Ansprüche 1 bis 11, **dadurch gekennzeichnet, daß**, welche eine autonome unabhängige Gleichspannungsquelle (24) für Erschließung bzw. Versorgung der Detektionsschaltung (17) vorgesehen ist, es der positive Anschluß dieser Gleichspannungsquelle (24) ist, welche an den Faraday'schen Käfig (14) angeschlossen ist.

**13.** Spannungsprüfer nach einem der Ansprüche 1 bis 12, **dadurch gekennzeichnet, daß** die Länge (I) des Gegengewichtes (15) parallel zu der Achse des Faraday'schen Käfigs (14) ein Bruchteil des Abstandes L ist.

**14.** Spannungsprüfer nach Anspruch 13, **dadurch gekennzeichnet, daß** dieser Bruchteil zwischen einem Fünftel und einem Zwanzigstel liegt.

**Claims**

**1.** A single-pole voltage detector, in particular for overhead electrical lines, of the kind including, protected by a Faraday cage (14) having a longitudinal axis, between a contact electrode (12) and a counterweight (15), both external to the Faraday cage (14), a load resistor (16) at the terminals of which there is established a detector circuit (17) driving at least one indicator device (18), **characterized in that** the distance L separating the counterweight (15) from the contact electrode (12), on the one hand, and the active surface area S of said counterweight (15), on the other hand, simultaneously satisfy the following two conditions:

$$L > 200 \text{ mm} \qquad (I)$$

$$50 \text{ mm}^2 < S < 500 \text{ mm}^2 \qquad (II)$$

2. A voltage detector according to claim 1, **characterized in that** the counterweight (15) extends longitudinally relative to the Faraday cage (14), that is to say along its axis or parallel to that axis.

3. A voltage detector according to either claim 1 or claim 2, **characterized in that** the counterweight (15) is formed by a conductive wire.

4. A voltage detector according to claim 3, **characterized in that** the counterweight (15) is formed by one of the wires of a screened electrical cable (28) whose screen, shortened to expose the length (1) of wire necessary to constitute the counterweight (15), is appropriately connected to the Faraday cage (14), forming a tubular extension (22) thereof.

5. A voltage detector according to either claim 3 or claim 4, **characterized in that** it includes a test circuit (30) that is controlled by a test button (31) accessible to an operator, is adapted to apply to the detector circuit (17), in parallel with the load resistor (16), a particular test voltage, and is operatively disposed between the detector circuit (17) and a conductive wire (32) connected to the free end of the wire forming the counterweight (15).

6. A voltage detector according to any of claims 3 to 5, **characterized in that** the Faraday cage (14) is formed, on the one hand, by a bell-shaped part (33), at the top of which is the contact electrode (12), and, on the other hand, by a bottom part (34) which closes a lower end of the bell-shaped part (33) and through which the conductive wire counterweight (15) passes.

7. A voltage detector according to claim 6, **characterized in that** the bottom part (34) has a projecting tube (44) on its bottom surface to house and protect the conductive wire counterweight (15).

8. A voltage detector according to either claim 6 or claim 7, **characterized in that** the bottom part (34) and the bell-shaped part (33) are clipped together.

9. A voltage detector according to any of claims 3 to 8, **characterized in that** it has a bell-shaped outer case (38) which is closed at a lower end by an end cap (40) and which provides the necessary space (42) between the Faraday cage (14) and said end cap (40) for spacing the conductive wire forming the counterweight (15) from the contact electrode (12) and for extending that wire.

10. A voltage detector according to claim 9, **characterized in that** the indicator device (18) includes at least one indicator lamp (25V, 25R) carried by the Faraday cage (14) and a light guide (46) is provided inside the outer case (38) between said Faraday cage (14) and the end cap (40), in line with said indicator lamp (25V, 25R), and extending outside said end cap (40).

11. A voltage detector according to claim 10, **characterized in that** it includes a test circuit (30) controlled by a test button (31) and a rod (50) in the outer case (38) whose end (51) is accessible from outside the end cap (40) and which, to enable operation of the test button (31), is mobile in said outer envelope (38) between said end cap (40) and the Faraday cage (14).

12. A voltage detector according to any of claims 1 to 11, **characterized in that** it includes an autonomous direct current voltage source (24) for the detector circuit (17) and said direct current voltage source (24) has a positive terminal connected to the Faraday cage (14).

13. A voltage detector according to any of claims 1 to 12, **characterized in that** the length (1) of the counterweight (15) measured parallel to the axis of the Faraday cage (14) is a fraction of the distance L.

14. A voltage detector according to claim 13, **characterized in that** said fraction is from one fifth to one twentieth.

FIG.1

FIG.2

FIG.3

FIG.4

FIG.5